# EUROPEAN PATENT APPLICATION

(11) **EP 2 123 688 A1**
(43) Date of publication of application: **25.11.2009**
(21) Application number: 08721664.4
(22) Date of filing: 04.03.2008
(51) Int. Cl.: C08G 59/14, C08G 59/32, H01L 23/29, H01L 23/31, H05K 1/03

(54) **NOVEL PHOSPHORUS-CONTAINING EPOXY RESIN, EPOXY RESIN COMPOSITION ESSENTIALLY CONTAINING THE EPOXY RESIN, AND CURED PRODUCT OF THE EPOXY RESIN COMPOSITION**

(30) Priority: 05.03.2007 JP 2007054780
(71) Applicant: Tohto Kasei Co., Ltd., Tokyo 101-0021 (JP)
(72) Inventor: YOKOYAMA, Naoki, Kitakyusyu-shi, Fukuoka 804-0835 (JP); ISHIHARA, Kazuo, Sodegaura-shi Chiba 299-0266 (JP); NAKANISHI, Tetsuya, Sodegaura-shi Chiba 299-0266 (JP)
(74) Representative: Albrecht, Thomas
(86) International application number: PCT/JP2008/054248
(87) International publication number: WO 2008/108485

(57) **Abstract**

Disclosed is a novel phosphorous containing epoxy resin having a naphthalene skeletal represented by represented by following general formula (1), a is 1, 2, 3, 4, 5 or 6; b is 1, 2, 3, 4, 5, 6 or 7; c is 0, 1, 2, 3 or more; X represents benzene, naphthalene, anthracene, phenanthrene or biphenyl; and Y represents, for example, a group represented by following general formula (3). In formula (3), d is 0 or 1; and R₁ and R₂ represent a straight chain, branched or cyclic hydrocarbon group, or alternatively, R₁ and R₂ may combine together to form a ring structure. This epoxy resin is suitable for an insulating material such as a copper-clad laminate used in an electronic circuit board and a sealing material, molding material, casting material, adhesive or film material used in an electric component. Furthermore, this epoxy resin is suitable as a material as material for an electrically insulating coating.

## Description

### FIELD OF THE INVENTION

The present invention relates to a novel epoxy phosphorus-containing resin, epoxy resin composition and cured product of the epoxy resin composition, which is useful for a resin composition for a copper-clad laminated board production used in an electronic circuit board or useful as sealing materials, molding materials, casting materials, adhesives or materials for electric insulation varnish used for electronic parts.

### DESCRIPTION OF THE PRIOR ART

In general, an epoxy resin is widely used for electronic parts, electrical equipments, car parts, FRP or sports goods because it is excellent in adhesive property, heat resistance and molding ability. Especially, a copper-clad laminated board and a sealing material that are used in electronic parts or electric equipments are strongly required to have safety such as prevention of a fire or retardation, therefore, brominated epoxy resin, which has these properties, is conventionally used. Although brominated epoxy resin has a problem that specific gravity of it is high, brominated epoxy resins is recognized as an useful electronic or electric material because flame retarding property can be provided by introducing halogen, especially bromine, to epoxy resin, and since an epoxy resin has excellent reactivity, good cured product can be easily obtained. However, recently, requirement to have physical properties of to be light, thin, short and small for electric goods is gradually becoming strong. Considering such a social requirement, halogenated epoxy resins whose specific gravity is high cannot be said as a suitable material from the view point of lightening requirement. Further, when halogenated epoxy resins are used for long term at high temperature, dissociation of halide takes place and corrosion of circuit is caused. Furthermore, since at burning out treatment of used electronic parts or electric goods, harmful compositions such as halide are formed, use of halogen is becoming a problem from a view point of environmental pollution, and investment for development of material which replaces halogenated resin is started. The inventors of this invention are earnestly challenged the problem, and invented a phosphorus containing epoxy resin which satisfy the requirement to have physical properties of to be light, thin, short and small and dissolve the problem of corrosion of circuit and formation of harmful compositions such as halide (patent documents 1-2). However, further improvement for heat resistance of cured product or reduction of water absorbing ratio is required.
Patent document 1: JPH11-166035 publication
Patent document 2: JPH11-279258 publication

### DISCLOSURE OF THE INVENTION

The inventors of the present invention continued earnest study to accomplish further improvement of heat resistance and reduction of water absorption ratio of a phosphorus containing epoxy resin to which flame retardation is provided without using halogen, and found out that phosphorus containing ratio can be reduced without spoiling flame retarding property by use of novel phosphorus containing epoxy resin to which specific skeletal, that is, naphthalene skeletal is introduced. By reducing phosphorus content, cured product characterized to have high heat resistance and low water absorption ratio can be obtained and accomplished the present invention. As a conventional method for improvement of heat resistance or water resistance, a method to introduce naphthalene skeletal can be mentioned, however, the object of present invention cannot be accomplished by naphthol novolac epoxy resins. And specific epoxy resin containing naphthalene skeletal represented by general formula (7) can accomplish the object of the present invention. However, among specific epoxy resins that possesses naphthalene skeletal, there are compounds whose dissolving ability to solvent is not good and deposits crystal, therefore, it is difficult to prepare a varnish at the preparation of a prepreg. Meanwhile, the novel epoxy resin of the present invention can improve dissolving ability to solvent remarkably by reacting epoxy resin possessing naphthalene skeletal with organic phosphorous compound represented by general formula (8) and/or general formula (9), therefore, it becomes possible to prepare a prepreg by varnish characterized not to deposit crystal and is stabilized. The object of the present invention is to provide novel phosphorous containing epoxy resin, phosphorous containing epoxy resin composition and cured product thereof which are suited to a copper-clad laminated board used in an electronic circuit board and a sealing material, a molding material, an adhesive, a material for electric insulation coating and an electric insulation film.

That is, essential point of the present invention is novel phosphorous containing epoxy resin, phosphorous containing epoxy resin composition and cured product thereof containing naphthalene skeletal represented by general formula (1). 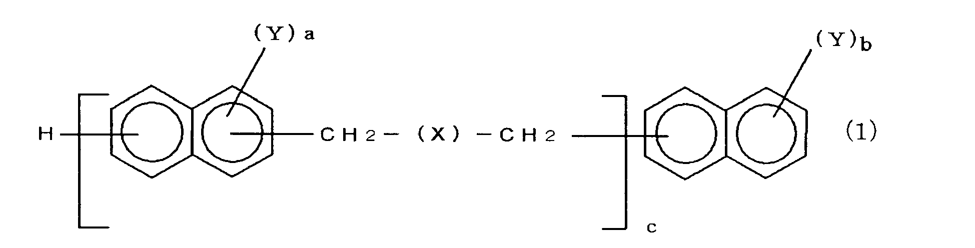 wherein,
a: 1, 2, 3, 4, 5, 6
b: 1, 2, 3, 4, 5, 6, 7
c: 0, 1, 2, 3, ···
X indicates benzene, naphthalene, anthracene, phenanthrene or biphenyl,
Y indicates general formulae (2)-(4), and at least one in one molecular is general formula (3) or general formula (4). 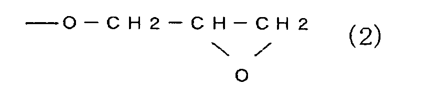 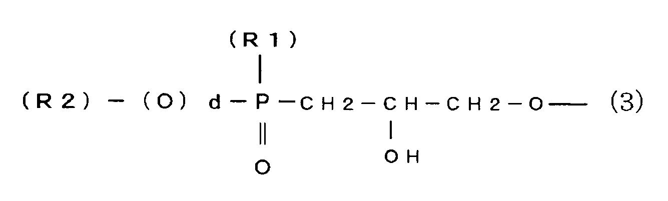
wherein,
d: 0 or 1
R₁ and R₂ indicate hydrocarbon group and can be normal chain, branch chain or cyclic structure. Or R₁ can bond with R₂ and can form cyclic structure. 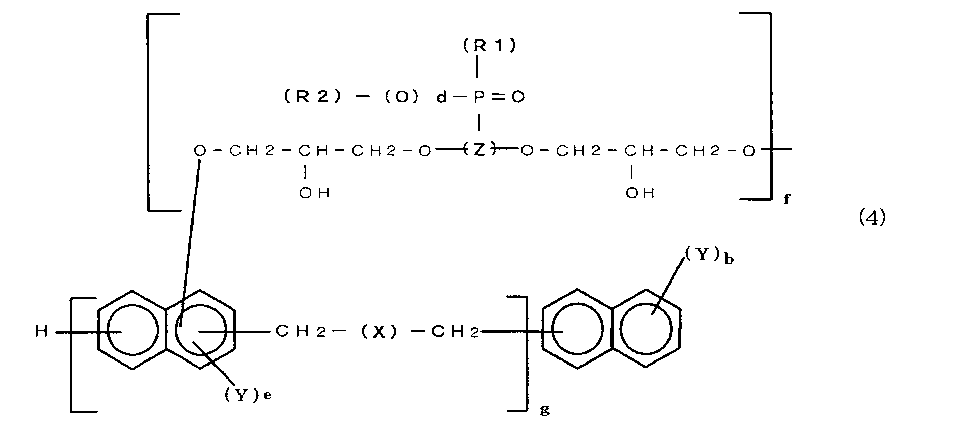
wherein,
e: 1, 2, 3, 4, 5, 6
b: 1, 2, 3, 4, 5, 6, 7
g: , 2, 3, ···
d: 0 or 1
f: 1, 2, 3, 4, 5, 6
f + e ≦ 6
R₁ and R₂ indicate hydrocarbon group and can be normal chain, branch chain or cyclic structure. Or R₁ can bond with R₂ and can form cyclic structure.
X indicates benzene, naphthalene, anthracene, phenanthrene or biphenyl,
Y indicates general formulae (2)-(4),
Z indicates general formulae (5)-(6). 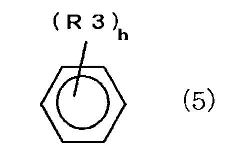
wherein,
h: 0, 1, 2, 3
R₃: indicates hydrocarbon group and can be normal chain, branch chain or cyclic structure. 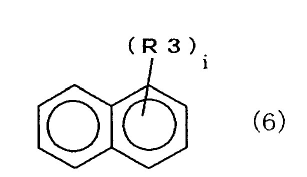
wherein,
i: 0, 1, 2, 3, 4, 5
R₃: indicates hydrocarbon group and can be normal chain, branch chain or cyclic structure.

Further, essential point of the present invention is to use said flame retarded novel phosphorous containing epoxy resin, phosphorous containing epoxy resin composition and cured product thereof as a resin composition for copper-clad laminated board production used in an electronic circuit board and a sealing material, a molding material, an adhesive and material for electric insulation coating.

### BRIEF INSTRUCTION OF DRAWINGS

Fig. 1 shows GPC chart of epoxy resin obtained in Example 2.
Fig.2 shows FTIR chart of epoxy resin obtained in Example 2.

### PREFERRED EMBODIMENT OF THE INVENTION

The present invention will be illustrated more in detail.

Novel phosphorous containing epoxy resin possessing naphthalene skeletal represented by general formula (1) can be obtained by reacting epoxy resin possessing naphthalene skeletal represented by general formula (7) with phosphorous compounds represented by general formula (8) and/or general formula (9). 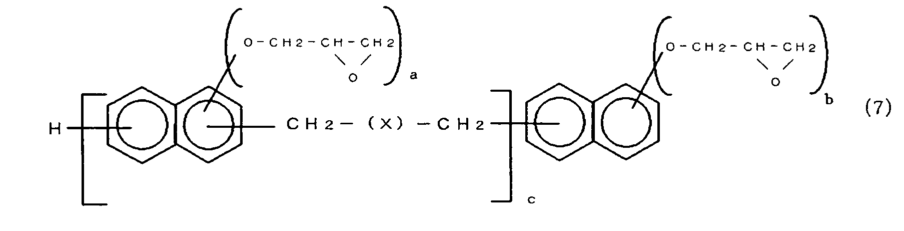 wherein,
a: 1, 2, 3, 4, 5, 6
b: 1, 2, 3, 4, 5, 6, 7
c: 0, 1, 2, 3, ···
X indicates benzene, naphthalene, anthracene, phenanthrene or biphenyl. 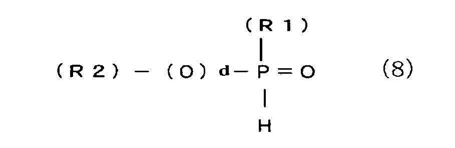
wherein,
d: 0 or 1
R₁ and R₂ indicate hydrocarbon group and can be normal chain, branch chain or cyclic structure. Or R₁ can bond with R₂ and can form cyclic structure. 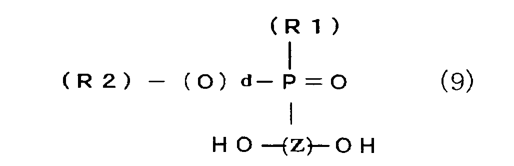
wherein,
d: 0 or 1
R₁ and R₂ indicate hydrocarbon group and can be normal chain, branch chain or cyclic structure. Or R₁ can bond with R₂ and can form cyclic structure.
Z indicates general formulae (5)-(6).

As an epoxy resin represented by general formula (7), epoxy resins disclosed in JPH03-000717 publication, JPH03-090075 publication, JP2006-160868 publication or JP2004-123859 publication can be mentioned, for example, ESN-155, ESN-185V and ESN-175 of ESN-100 series (product of Tohto Kasei, β -naphtholallalkyl epoxy resins), ESN-355 and ESN-375 of ESN-300 series (product of Tohto Kasei, dinaphthol allalkyl epoxy resins), ESN-475V and ESN-485 of ESN-400 series (product of Tohto Kasei, α -naphtholallalkyl epoxy resins) can be mentioned, however, not intended to be restricted to these compounds, and can be used together with. Further, other epoxy resins can be used in the limit not to influence to physical properties.

Organic phosphorous compounds to be used in the present invention represented by general formula (8) is an organic phosphorous compounds characterized that active hydrogen which can react with quinines or a functional group, such as glycidyl group or vinyl group is bonded with phosphorus atom, concretely, HCA (product of Sanko Co., Ltd., 9,10-dihydro-9-oxa-10-phosphaphenanthrene-10-oxide), diphenylphosphine oxide or CPHO (product of Nippon Chemical Industrial Co., Ltd., cyclooctylenephosphineoxide) can be mentioned. Organic phosphorous compounds to be used in the present invention represented by general formula (9) is a phosphorous containing phenolic compound obtained by reacting active hydrogen of phosphorous compounds represented by general formula (8) with quinines, concretely, HCA-HQ (product of Sanko Co., Ltd., 10-(2,5-dihydroxyphenyl)-10-dihydro -9-oxa-10-phosphaphenanthrene-10-oxide), 10-(2,7-dihydroxynaphthyl)-10-dihydro-9-oxa-10-phosphaphenanthrene-10-oxide, PPQ (product of Hokko Chemical Industry Co., Ltd., diphenylphosphinyl hydroquinone), diphenylphosphinylnaphthoquinine, CPHO-HQ (product of Nippon Chemical Industrial Co., Ltd., cyclooctylene phosphinyl-1,4-benzenediol) or cyclooctylenephosphinyl-1,4-naphthalenediol can be mentioned.
In the present invention, any kinds of product represented by general formula (8) and/or general formula (9) can be used, and not intended to be restricted to these compounds. And these compounds can be used together with.

Phosphorous containing phenolic compound represented by general formula (9) can be obtained by methods disclosed in JPH5-214068 publication, Zh. Obshch. Khim. 42(11), pp 2415-2418 (Russian general magazine), JPS60-126293 publication, JPS61-236787 publication or JPH5-331179 publication. At the preparation, operation such as purification or recrystallization are necessary to pick up formed multi functional phosphorus containing phenolic compound alone. However, if organic phosphorous compounds characterized that active hydrogen is bonded with phosphorus atom, which is a compound represented by general formula (8), is properly remained, not only such operations become not necessary, but also it becomes possible to drop epoxy resin viscosity of after reaction by increasing phosphorous content in resin.

Reaction of naphthalene skeletal containing epoxy resin represented by general formula (7) with phosphorus compound represented by general formula (8) and/or general formula (9) can be carried out by public known method and can be progressed by 100-200°C desirably 120-180°C reaction temperature under constant stirring condition.

Reaction time can be decided by measuring epoxy equivalent. Epoxy equivalent can be measured by a method regulated in JIS K7236. By reaction of naphthalene skeletal containing epoxy resin represented by general formula (7) with phosphorus compound represented by general formula (8) and/or general formula (9), epoxy equivalent becomes larger and end point of reaction can be decided by comparison with theoretical epoxy equivalent.

In a case when reaction rate is too slow, it is possible to improve productivity by use of catalyst if necessary. Concretely, various kinds of catalysts, for example tertiary amines such as benzyldimethyl amine, quaternary ammonium salts such as tetramethylammonium chloride, phosphines such as triphenyl phosphine, or tris(2,6-dimethoxyphenyl) phosphine, phosphonium salts such as ethyltriphenylphosphoniumbromide, imidazoles such as 2-methylimidazole or 2-ethyl-4-methylimidazole can be used.

As a curing agent to be used for a composition of the present invention, any kind of conventional curing agent for epoxy resin can be used. For example, various multi valent phenolic resins such as phenol novolac resins, acid unhydride, amines represented by DICY, hydrazides or acidic polyesters can be mentioned, and these curing agents can be used alone or can be used together with.

To the composition of the present invention, a curing accelerator such as tertiary amine, quaternary ammonium salt, phosphines or imidazoles can be blended if necessary. Further, if necessary, reinforcing agent such as inorganic filler or glass cloth·aramid fiber, filler or pigment can be blended.

Evaluation tests of properties of laminated boards obtained by use of novel phosphorus containing epoxy resin are made. According to evaluation results, it becomes clear that epoxy resin composition and cured product thereof characterized to have high heat resistance, lower water absorping ratio and flame retarding property not containing halides can be obtained. Said epoxy resin, epoxy resin composition and cured product thereof is understood to be useful as a resin composition for copper-clad laminated board production used in an electronic circuit board and a sealing material, a molding material, an adhesive and material for electric insulation coating.

### EXAMPLES

The present invention will be illustrated more in detail according to Examples and Comparative Examples, however, not intending to limit the scope of claims of the present invention to Examples. A laminated board is prepared by condition mentioned below. Obtained epoxy resin, a curing agent and a curing accelerator if necessary, are dissolved in solution and impregnate with glass cloth. Solution is removed by drying process and obtained a prepreg. Four sheets of prepreg and copper foil are laminated and heat pressed, then cured laminated board is obtained. Flame retarding property is measured according to UL (Underwriter Laboratorics) standard. Copper foil peeling strength is measured according to JIS C 6481 5.7 standard. And glass transition point is measured by Exster 6000 DSC, which is product of SII Nano Technology Inc. Water absorbing ratio is measured as follows. Specimen is set in condition of 85°C × 85% humidity for 500 hours. Initial weight and weight after 500 hours are measured and increased weight ratio is calculated and water absorbing ratio is obtained.

### Example 1

In a four necks glass separable flask providing stirrer, thermometer, condenser and nitrogen gas introducing device, 56.1 weight parts of HCA and 131 weight parts of toluene are poured and dissolved by heating. Then, 39.0 weight parts of 1,4-naphthoquinone is added divisionally paying attention to temperature up by reaction heat. At this point, molar ratio of 1,4-naphthoquinone and HCA is 1,4-naphthoquinone/HCA = 0.95. After reaction, 254.5 weight parts of ESN-485 is added and stirred by introducing nitrogen gas and heated to 130°C so as to remove toluene. 0.1 weight parts of triphenylphosphine is added and reacted at 160°C for 4 hours. Epoxy equivalent of obtained epoxy resin is 349.6 g/eq, phosphorus content is 0.80 weight %. Curing agent (DICY) and curing accelerator (2E4MZ) are added to the obtained epoxy resin by ratio indicated in Table 1, and evaluation of laminated board is carried out by aforementioned method. Results are shown in Table 1.

### Example 2

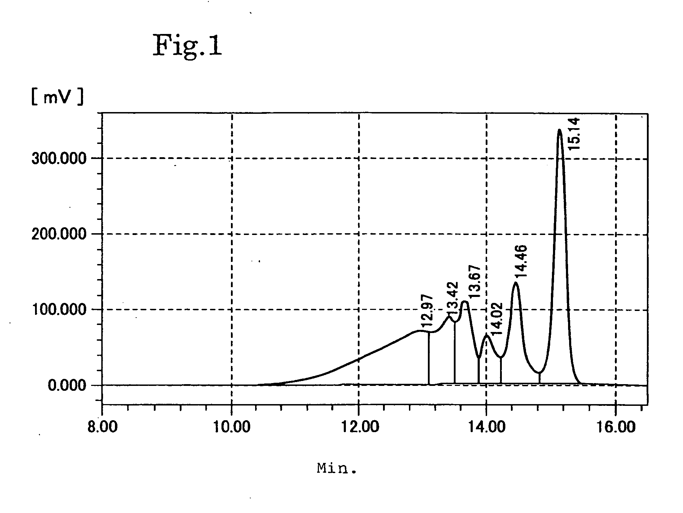

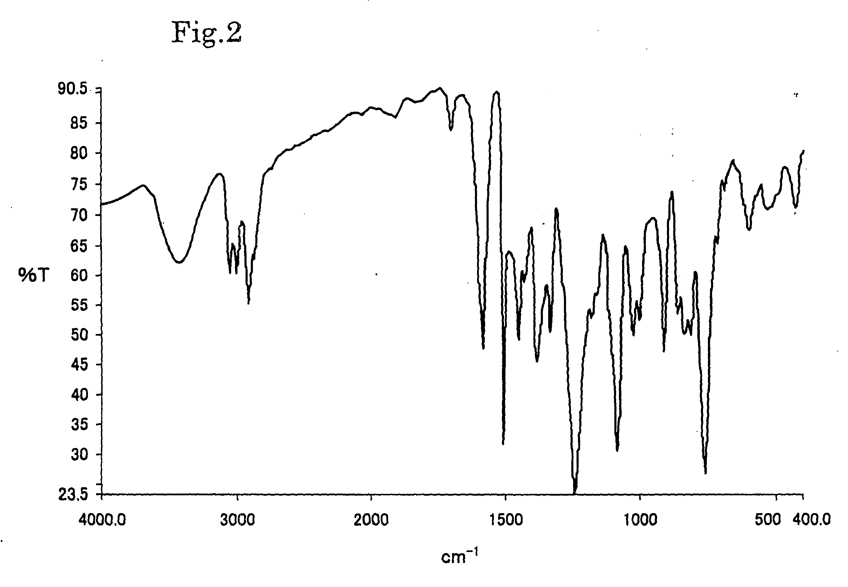

Same operations as to Example 1 are carried out except using 84.5 weight parts of HCA, 51.7 weight parts of 1,4-naphthoquinone, 127 weight parts of toluene, 663.0 weight parts of ESN-485, 0.1 weight parts of triphenyl phosphine and blending 200.8 weight parts of EPPN-501H (product of Nippon Kayaku Co., Ltd., three functional epoxy resin) with ESN-485. Molar ratio is 1,4-naphthoquinone/HCA = 0.83. Epoxy equivalent of obtained epoxy resin is 346.7 g/eq and phosphorus content is 1.2 weight %. GPC chart and FTIR chart of obtained epoxy resin are shown in Figs 1 and 2. Curing agent (DICY) and curing accelerator (2E4MZ) are added to obtained epoxy resin by ratio indicated in Table 1, and evaluation of laminated board is carried out according to aforementioned method. Results are shown in Table 1.

### Example 3

Same operations as to Example 1 are carried out except using 70.1 weight parts of HCA, 46.2 weight parts of 1,4-naphthoquinone, 235 weight parts of xylene, 209.8 weight parts of ESN-155 instead of ESN-485 and 0.1 weight parts of triphenyl phosphine. Molar ratio is 1,4-naphthoquinone/HCA = 0.900. Epoxy equivalent of obtained epoxy resin is 326.1 g/eq and phosphorus content is 1.0 weight %. Curing agent (DICY) and curing accelerator (2E4MZ) are added to obtained epoxy resin by ratio indicated in Table 1, and evaluation of laminated board is carried out according to aforementioned method. Results are shown in Table 1.

### Example 4

Same operations as to Example 1 are carried out except using weight parts of HCA to 9.0, using 70.0 weight parts of HCA-HQ instead of 1,4-naphthoquinone, using 721.0 weight parts of ESN-155 instead of ESN-485 and blending 200.0 weight parts of ESN-375. Epoxy equivalent of obtained epoxy resin is 274.9 g/eq and phosphorus content is 0.8 weight %. Curing agent (DICY) and curing accelerator (2E4MZ) are added to obtained epoxy resin by ratio indicated in Table 1, and evaluation of laminated board is carried out according to aforementioned method. Results are shown in Table 1.

### Comparative Example 1

Same operations as to Example 1 are carried out except using 127.0 weight parts of HCA, 62.1 weight parts of bisphenol A (product of Nippon Steel Chemical Co., Ltd.), 810.9 weight parts of YDPN-638 (product of Tohto Kasei Co., Ltd., phenol novolac epoxy resins) and 0.2 weight parts of triphenyl phosphine. Epoxy equivalent of obtained epoxy resin is 298.6 g/eq and phosphorus content is 1.8 weight %.
Curing agent (DICY) and curing accelerator (2E4MZ) are added to obtained epoxy resin by ratio indicated in Table 1, and evaluation of laminated board is carried out according to aforementioned method. Results are shown in Table 1.

### Comparative Example 2

Same operations as to Example 1 are carried out except using 70.5 weight parts of HCA, 64.7 weight parts of bisphenol A, 864.8 weight parts of YDCN-701 (product of Tohto Kasei Co., Ltd., cresol novolac epoxy resins) and 0.1 weight parts of triphenyl phosphine. Molar ratio is 1,4-naphthoquinone/HCA = 0.93. Epoxy equivalent of obtained epoxy resin is 293.7 g/eq and phosphorus content is 1.0 weight %.
Curing agent (DICY) and curing accelerator (2E4MZ) are added to obtained epoxy resin by ratio indicated in Table 1, and evaluation of laminated board is carried out according to aforementioned method. Results are shown in Table 1.

### Comparative Example 3

Same operations as to Example 1 are carried out except using 56.1 weight parts of HCA, 37.0 weight parts of 1,4-naphthoquinone, 235 weight parts of xylene, 906.9 weight parts of ZX-1142L (product of Tohto Kasei Co., Ltd., α -naphthol novolac epoxy resins) instead of ESN-485, and 0.1 weight parts of triphenyl phosphine. Molar ratio is 1,4-naphthoquinone/HCA = 0.90. Epoxy equivalent of obtained epoxy resin is 298.9 g/eq and phosphorus content is 0.8 weight %.
Curing agent (DICY) and curing accelerator (2E4MZ) are added to obtained epoxy resin by ratio indicated in Table 1, and evaluation of laminated board is carried out according to aforementioned method. Results are shown in Table 1.

### Comparative Example 4

Same operations as to Example 1 are carried out except using 141.0 weight parts of HCA, 77.4 weight parts of 1,4-naphthoquinone, 329 weight parts of toluene, 631.6 weight parts of YDPN-638 instead of ESN-485, and 150.0 weight parts YDF-170 and 0.2 weight parts of triphenyl phosphine. Molar ratio is 1,4-naphthoquinone/HCA = 0.75. Epoxy equivalent of obtained epoxy resin is 306.4 g/eq and phosphorus content is 2.0 weight %. Curing agent (DICY) and curing accelerator (2E4MZ) are added to obtained epoxy resin by ratio indicated in Table 1, and evaluation of laminated board is carried out according to aforementioned method.
Results are shown in Table 1.

### Comparative Example 5

Same operations as to Example 1 are carried out except using 70.4 weight parts of HCA, 13.3 weight parts of 1,4-naphthoquinone, 164 weight parts of toluene, 249.6 weight parts of YDPN-638 instead of ESN-485 and 0.2 weight parts of triphenyl phosphine. Molar ratio is 1,4-naphthoquinone/HCA = 0.25. Epoxy equivalent of obtained epoxy resin is 287.1 g/eq and phosphorus content is 3.0 weight %.
33.3 weight parts of obtained epoxy resin and 66.7 weight parts of ESN-485 are blended and evaluation of laminated board is carried out. Results of evaluation of laminated board are shown in Table 1.

**Table 1**

| | Exp.1 | Exp.2 | Exp.3 | Exp.4 | Comp. Exp.1 | Comp. Exp.2 | Comp. Exp.3 | Comp. Exp.4 | Comp. Exp.5 |
|---|---|---|---|---|---|---|---|---|---|
| HCA | 56.1 | 84.5 | 70.1 | 9.0 | 127.0 | 70.5 | 56.1 | 141.0 | 70.4 |
| HCA-HQ | | | | 70.0 | | | | | |
| 1,4naphthoquinone | 39.0 | 51.7 | 46.2 | | | | 37.0 | 77.4 | 13.3 |
| ESN-485 | 254.5 | 663.0 | | | | | | | 666.7 |
| ESN-155 | | | 209.8 | 721.0 | | | | | |
| ESN-375 | | | | 200.0 | | | | | |
| BPA (bisphenol A) | | | | | 62.1 | 64.7 | | | |
| YDPN-638 | | | | | 810.9 | | | 631.6 | 249.6 |
| YDCN-701 | | | | | | 864.8 | | | |
| ZX-1142L | | | | | | | 906.9 | | |
| YDF-170 | | | | | | | | 150.0 | |
| EPPN-501HY | | 200.8 | | | | | | | |
| triphenyl phosphine | 0.1 | 0.1 | 0.1 | 0.1 | 0.2 | 0.1 | 0.1 | 0.2 | 0.2 |
| epoxy equivalent (g/eq) | 349.6 | 346.7 | 326.1 | 274.9 | 298.6 | 293.7 | 298.9 | 306.4 | 287.1 |
| phosphorus content (%) | 0.8 | 1.2 | 1.0 | 0.8 | 1.8 | 1.0 | 0.8 | 2.0 | 3.0 |
| synthesized epoxy resin | 100.00 | 100.00 | 100.00 | 100.00 | 100.00 | 100.00 | 100.00 | 100.00 | 33.33 |
| ESN-485 | | | | | | | | | 66.67 |
| DICY | 3.00 | 3.03 | 3.22 | 3.82 | 3.52 | 3.58 | 3.51 | 3.43 | 3.66 |
| 2E4MZ | 0.45 | 0.40 | 0.47 | 0.35 | 0.03 | 0.01 | 0.02 | 0.01 | 0.60 |
| flame retarding property | V-0 | V-0 | V-0 | V-0 | V-0 | V-1 | V-1 | V-0 | V-1 |
| average combustion time (sec) | 8 | 5 | 8 | 9 | 6 | 18 | 24 | 8 | 12 |
| glass transition point (°C) | 175.2 | 171.8 | 151.4 | 172.5 | 129.4 | 142.1 | 170.2 | 144.2 | 148.1 |
| copper foil peeling strength (Kgf/cm) | 1.22 | 1.46 | 1.44 | 1.40 | 1.49 | 1.40 | 0.95 | 1.47 | 1.40 |
| layer adhesive strength (Kgf/cm) | 1.00 | 1.00 | 1.08 | 1.10 | 0.85 | 0.68 | 0.44 | 0.91 | 0.92 |
| water absorbing ratio (%) | 1.0 | 1.1 | 1.0 | 1.2 | 2.0 | 1.6 | 1.2 | 1.8 | 1.4 |

According to above mentioned results of Examples and Comparative Examples, it is clearly understood from physical properties mentioned in Comparative Examples of Table 1, that in a case of phosphorus containing novolac epoxy resins, good flame retardant cannot be obtained when phosphorus content is 1%. When phosphorus content is increased to 2% so as to improve flame retardant as shown in Comparative Example 4, water absorbing ratio is not good. Meanwhile, in a case of Comparative Example 3, which introduce naphthalene skeletal, phosphorous containing naphthol novolac epoxy resins cannot accomplish good flame retarding property by phosphorus content of 0.8%. By blending phosphorous containing naphthol novolac epoxy resins with naphthol allalkyl epoxy resin, good effects can not be obtained in flame retarding property, heat resistance and water absorbing ratio.

Phosphorus content of novel epoxy resin synthesized by technique of the present invention is 0.8% and has good flame retarding property, and can obtain a cured product having good heat resistance and low water absorbing ratio. Thus, novel phosphorous containing epoxy resin and novel phosphorous containing epoxy resin composition has good flame retarding property by lower phosphorous content, further is excellent in heat resistance, adhesive property and water absorbing ratio, therefore, is suited to an electric insulation material such as copper-clad laminated board used for an electro circuit board, and a sealing material, a molding material, an adhesive and a material for film, further is useful as a material for electric insulation coating.

### INDUSTRIAL APPLICABILITY

Novel phosphorus containing epoxy resin and novel phosphorous containing epoxy resin composition has good flame retarding property by lower phosphorous content, further are excellent in heat resistance, adhesive property and water absorbing ratio, therefore, is suited to an electric insulation material such as copper-clad laminated board used for an electro circuit board, and a sealing material, a molding material, an adhesive and a material for film, further is suited as a material for electric insulation coating.

## Claims

1. Novel phosphorous containing epoxy resin containing naphthalene skeletal represented by general formula (1), 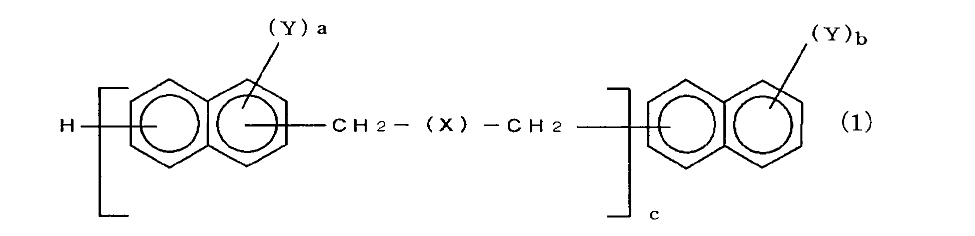 wherein,
a: 1, 2, 3, 4, 5, 6
b: 1, 2, 3, 4, 5, 6, 7
c: 0, 1, 2, 3, ···
X indicates benzene, naphthalene, anthracene, phenanthrene or biphenyl,
Y indicates general formulae (2)-(4), and at least one in one molecular is general formula (3) or general formula (4), 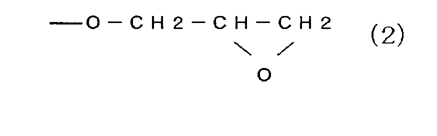 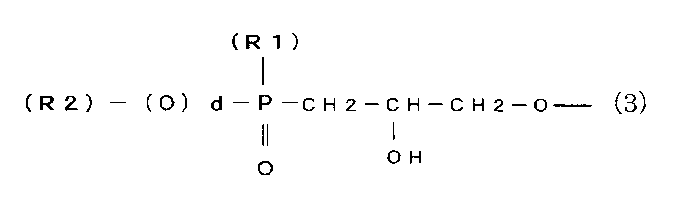
wherein,
d: 0 or 1
R₁ and R₂ indicate hydrocarbon group and can be normal chain, branch chain or cyclic structure, or R₁ can bond with R₂ and can form cyclic structure, 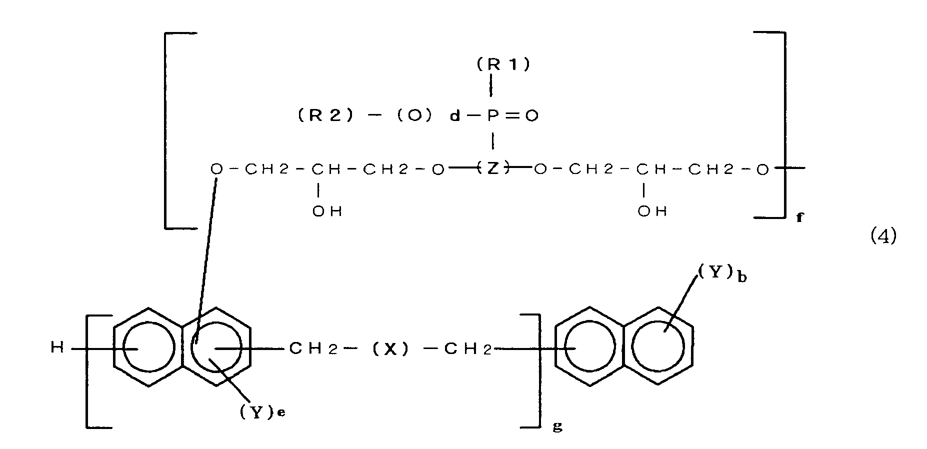
wherein,
e_{:} 1, 2, 3, 4, 5, 6
b: 1, 2, 3, 4, 5, 6, 7
g: , 2, 3, ...
d: 0 or 1
f: 1, 2, 3, 4, 5, 6
f + e ≦ 6
R₁ and R₂ indicate hydrocarbon group and can be normal chain, branch chain or cyclic structure, or R₁ can bond with R₂ and can form cyclic structure,
X indicates benzene, naphthalene, anthracene, phenanthrene or biphenyl,
Y indicates general formulae (2)-(4),
Z indicates general formulae (5)-(6), 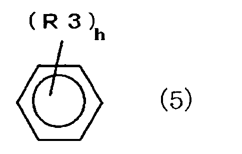
wherein,
h: 0, 1, 2, 3
R₃: indicates hydrocarbon group and can be normal chain, branch chain or cyclic structure, 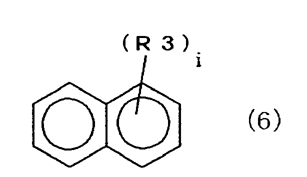
wherein,
i: 0, 1, 2, 3, 4, 5
R₃: indicates hydrocarbon group and can be normal chain, branch chain or cyclic structure.

2. Novel phosphorous containing epoxy resin of claim 1 obtained by reacting epoxy resin possessing naphthalene skeletal represented by general formula (7) with phosphorous compounds represented by general formula (8) and/or general formula (9), 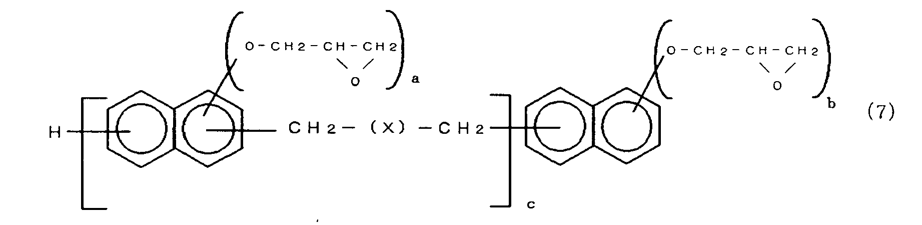 wherein,
a: 1, 2, 3, 4, 5, 6
b: 1, 2, 3, 4, 5, 6, 7
c: 0, 1, 2, 3, **···**
X indicates benzene, naphthalene, anthracene, phenanthrene or biphenyl. 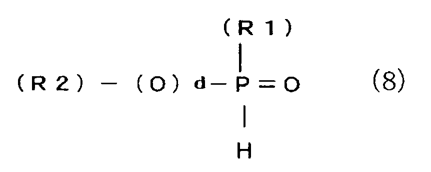
wherein,
d: 0 or 1
R₁ and R₂ indicate hydrocarbon group and can be normal chain, branch chain or cyclic structure, or R₁ can bond with R₂ and can form cyclic structure, 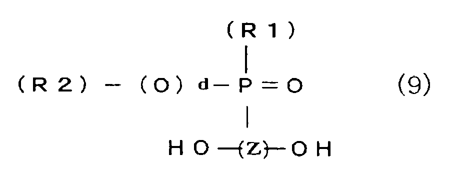
wherein,
d: 0 or 1
R₁ and R₂ indicate hydrocarbon group and can be normal chain, branch chain or cyclic structure, or R₁ can bond with R₂ and can form cyclic structure,
Z indicates general formulae (5)-(6).

3. A phosphorus containing epoxy resin composition obtained by blending a curing agent to the phosphorus containing epoxy resin of claim 1 or claim 2.

4. A epoxy resin laminated board obtained by using phosphorus containing epoxy resin composition of claim 3.

5. An epoxy resin sealing material obtained by using phosphorus containing epoxy resin composition of claim 3.

6. An epoxy resin molding material obtained by using phosphorus containing epoxy resin composition of claim 3.

7. An epoxy resin cured product obtained by curing phosphorus containing epoxy resin composition according to anyone of claims 3 to 6.

## Amended claims

### Amended claims under Art. 19.1 PCT

1. (amended) Novel phosphorous containing epoxy resin, phosphorous containing epoxy resin composition and cured product thereof containing naphthalene skeletal represented by general formula (1), 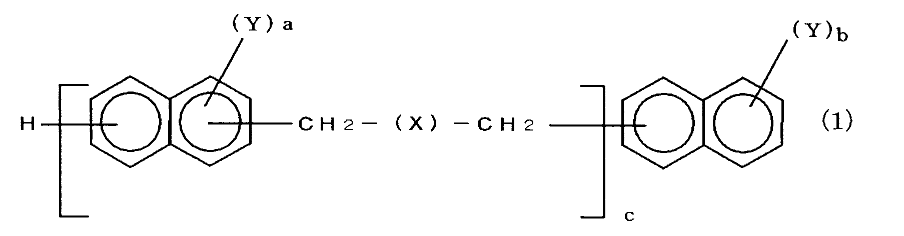 wherein,
a: indicates integer of 1, 2, 3 and 1 is indispensable
b: indicates integer of 1, 2, 3
c: 0, 1, 2, 3, **···**
X indicates benzene, naphthalene, anthracene, phenanthrene or biphenyl,
Y indicates general formulae (2)-(4), and at least one in one molecular is general formula (3) or general formula (4), 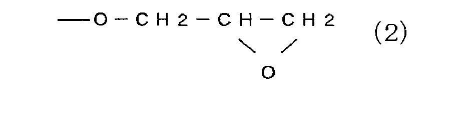 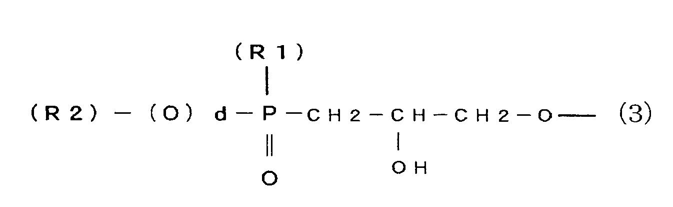
wherein,
d: 0 or 1
R₁ and R₂ indicate hydrocarbon group and can be normal chain, branch chain or cyclic structure, or R₁ bonds with R₂ and can form cyclic structure, 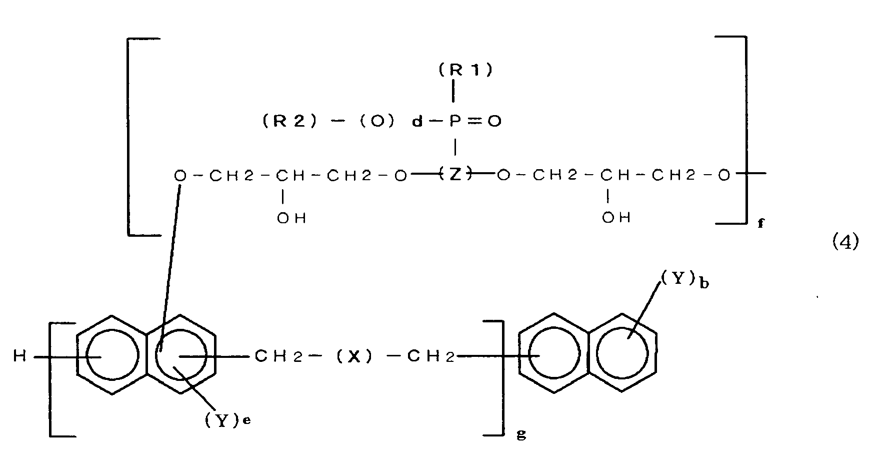
wherein,
e: indicates integer of 1, 2
b: 1, 2, 3, 4, 5, 6, 7
g: 1, 2, 3, **···**
d: 0 or 1
f: indicates integer of 1, 2, 3
sum total of f and e is integer of 1-3
R₁ and R₂ indicate hydrocarbon group and can be normal chain, branch chain or cyclic structure, or R₁ can bond with R₂ and can form cyclic structure,
X indicates benzene, naphthalene, anthracene, phenanthrene or biphenyl,
Y indicates general formulae (2)-(4),
Z indicates general formulae (5)-(6), 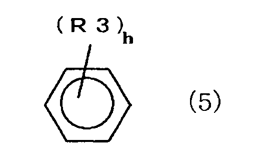
wherein,
h: 0, 1, 2, 3
R₃: indicates hydrocarbon group and can be normal chain, branch chain or cyclic structure, 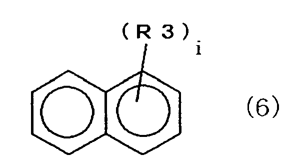
wherein,
i: 0, 1, 2, 3, 4, 5
R₃: indicates hydrocarbon group and can be normal chain, branch chain or cyclic structure.

2. (amended) Novel phosphorous containing epoxy resin of claim 1 obtained by reacting epoxy resin possessing naphthalene skeletal, which essentially contains epoxy resin of general formula (7) whose a and b are 1, with phosphorous compounds represented by general formula (8) and/or general formula (9), 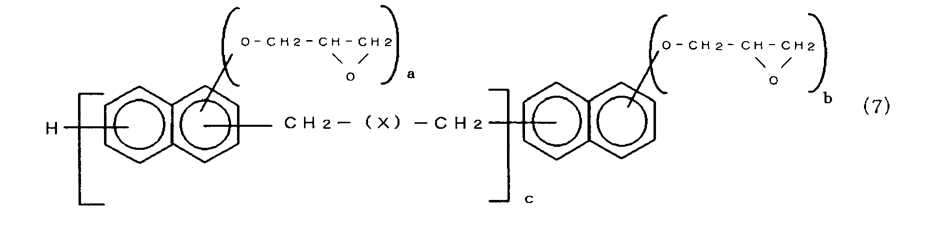 wherein,
a: indicates integer of 1, 2, 3
b: indicates integer of 1, 2, 3
c: 0, 1, 2, 3, **···**
X indicates benzene, naphthalene, anthracene, phenanthrene or biphenyl, 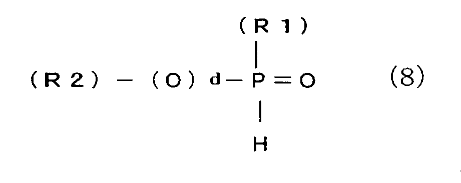
wherein,
d: 0 or 1,
R₁ and R₂ indicate hydrocarbon group and can be normal chain, branch chain or cyclic structure, or R₁ can bond with R₂ and can form cyclic structure, 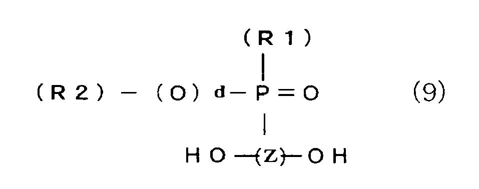
wherein,
d: 0 or 1,
R₁ and R₂ indicate hydrocarbon group and can be normal chain, branch chain or cyclic structure, or R₁ can bond with R₂ and can form cyclic structure,
Z indicates general formulae (5)-(6).

3. A phosphorus containing epoxy resin composition obtained by blending a curing agent to the phosphorus containing epoxy resin of claim 1 or claim 2.

4. A epoxy resin laminated board obtained by using phosphorus containing epoxy resin composition of claim 3.

5. An epoxy resin sealing material obtained by using phosphorus containing epoxy resin composition of claim 3.

6. An epoxy resin molding material obtained by using phosphorus containing epoxy resin composition of claim 3.

7. An epoxy resin cured product obtained by curing phosphorus containing epoxy resin composition according to anyone of claims 3 to 6.

Statement under Art. 19.1 PCT
·In Claim 1, "a : 1, 2, 3, 4, 5, 6" is amended to " a : indicates an integer of 1, 2, 3, wherein 1 is essential".

·In Claim 1, "b : 1, 2, 3, 4, 5, 6,7" is amended to " b : indicates an integer of 1, 2, 3".

·In Claim 1, "e : 1, 2, 3, 4, 5, 6" is amended to " e : indicates an integer of 1, 2".

·In Claim 1, "f : 1, 2, 3, 4, 5, 6" is amended to " f : indicates an integer of 1, 2, 3".

·In Claim 1, "f+e≦6" is amended to "sum total of f and e is an integer of 1-3".

·In Claim 2, "epoxy resins having naphthalene skeleton represented by general formula (7)" is amended to "epoxy resins having naphthalene skeleton represented by general formula (7), wherein epoxy resin of a and b is 1 is essential".

·In Claim 2, "a : 1, 2, 3, 4, 5, 6" is amended to " a : indicates an integer of 1, 2, 3".

·In Claim 2, "b : 1, 2, 3, 4, 5, 6,7" is amended to " b : indicates an integer of 1, 2, 3".

In claim 1, amendment of a, b, e and f is restricting a scope of the present invention. And also, in claim 2, amendment of a and b is restricting a scope of the present invention.

By said amendment, the present invention can be distinguish from Document 1 (JP2002-249540A), which is cited in the International Search Report, therefore, we think novelty and inventive step of the present invention are not denied by said Document 1.
